# EUROPEAN PATENT APPLICATION

(11) **EP 1 383 168 A1**
(43) Date of publication of application: **21.01.2004**
(21) Application number: 01926007.4
(22) Date of filing: 27.04.2001
(51) Int. Cl.: H01L 21/68, H05B 3/10, H05B 3/16, H05B 3/20

(54) **METHOD OF PRODUCING ELECTROSTATIC CHUCKS AND METHOD OF PRODUCING CERAMIC HEATERS**

(71) Applicant: IBIDEN CO., LTD., Ogaki-shi Gifu-ken 503-0917 (JP)
(72) Inventor: HIRAMATSU, Yasuji, c/o IBIDEN CO., LTD., Ibi-gun, Gifu 501-0695 (JP); ITO, Yasutaka, c/o IBIDEN CO., LTD., Ibi-gun, Gifu 501-0695 (JP)
(74) Representative: Müller-Boré & Partner Patentanwälte
(86) International application number: PCT/JP2001/003679
(87) International publication number: WO 2002/091458

(57) **Abstract**

The objective of the present invention is to provide a process for manufacturing an electrostatic chuck which does not have a dispersion in chucking force depending on place and is capable of adsorbing a semiconductor wafer evenly. A process for manufacturing an electrostatic chuck according to the present invention comprises steps of: printing a conductor containing paste for an electrode on a green sheet which has a surface roughness, Rmax, of 200 µm or less; forming a lamination by stacking another green sheet or other green sheets on said green sheet; and then sintering said lamination.

## Description

### Field of the Invention

The present invention relates to a process for manufacturing an electrostatic chuck and a process for manufacturing a ceramic heater, used mainly in the semiconductor industry, particularly to: a process for manufacturing an electrostatic chuck which does not have a dispersion in chucking force; and a process for manufacturing a ceramic heater which does not have a dispersion in calorific value.

### Background Art

Semiconductors are very important products necessary in various industries. A semiconductor chip is produced, for example, by slicing a silicon monocrystal into a given thickness to produce a silicon wafer, and then forming a plurality of integrated circuits and the like on this silicon wafer.

In the process for producing this semiconductor chip, a silicon wafer placed on an electrostatic chuck is subjected to various treatments such as etching and CVD to form a conductor circuit, an element and the like. At this time, corrosive gas such as gas for deposition or gas for etching is used; therefore, it is necessary to protect an electrostatic electrode layer from corrosion by the gas. Also, since it is necessary to induce adsorption power, the electrostatic electrode layer is usually coated with a ceramic dielectric film or the like.

As this ceramic dielectric film, a nitride ceramic has been conventionally used. For example, JP Kokai Hei 5-8140 discloses an electrostatic chuck, using a nitride such as aluminum nitride. Further, in JP Kokai Hei 9-48668, a carbon-containing aluminum nitride having an Al-O-N structure is disclosed.

Furthermore, a process for manufacturing such an electrostatic chuck is disclosed in JP Kokoku Hei 6-97677 and the like.

Such an electrostatic chuckmade of ceramic is manufactured by what is called a green sheet method wherein ceramic is produced in the way that: a lamination is formed by stacking green sheets; and then the lamination is sintered, as noted in JP Kokai Sho 62-264638, JP Kokai Sho 60-261377 and the like.

### Summary of the Invention

However, electrostatic chucks using these ceramics have a problem that chucking force thereof has a dispersion.

And further, ceramic heaters manufactured by the above-mentioned green sheet method also have a temperature-dispersion on the heating face.

The objective of the present invention is to reduce the dispersion of chucking force and the temperature-difference on the heating face of the electrostatic chuck and ceramic heater (hot plate) manufactured by a green sheet method.

As a result of investigation of the reason of the above-mentioned problem under the above-mentioned objective, the inventors have found out that: unexpectedly, a problem exist in a surface roughness of the green sheet used when a formed body is produced; and, by setting the surface roughness thereof to, as Rmax, 200µm or less, a dispersion of chucking force depending on place of an electrostatic chuck is eliminated. Thus, they have completed the present invention.

Inventors have also found out that by using such a green sheet as a green sheet for a ceramic heater, they can produce a ceramic heater wherein a dispersion of calorific value depending on place of the resistance heating element does not exist, and thus completed the present invention.

That is, a processfor manufacturing an electrostatic chuck of the present invention comprises steps of:
printing a conductor containing paste for an electrode on a green sheet which has a surface roughness, Rmax, of 200 µm or less; forming a lamination by stacking another green sheet or other green sheets on the above-mentioned green sheet; and then sintering the lamination.

The electrostatic chuck manufactured in the present invention is desirably in a disc shape having a diameter exceeding 150 mm.

Aprocess for manufacturing a ceramic heater of the present invention comprises steps of:
printing a conductor containing paste for a resistance heating element on a green sheet which has a surface roughness, Rmax, of 200 µm or less; forming a lamination by stacking another green sheet or other green sheets on the above-mentioned green sheet; and then sintering the above-mentioned lamination.

The ceramic heater manufactured in the present invention is desirably in a disc shape having a diameter exceeding 150 mm.

### Brief Description of the Drawings

Fig.1 (a) to (d) are sectional views that schematically illustrate a part of a process for manufacturing an electrostatic chuck according to the present invention.
Fig.2 is a sectional view that schematically illustrates one example of an electrostatic chuck manufactured by the process according to the present invention.
Fig.3 is a sectional view taken along A-A line of the electrostatic chuck illustrated in Fig. 2.
Fig.4 is a sectional view taken along B-B line of the electrostatic chuck illustrated in Fig. 2.
Fig.5 is a sectional view that schematically illustrates one example of an electrostatic chuck manufactured by the process according to the present invention.
Fig.6 is a sectional view that schematically illustrates one example of an electrostatic chuck manufactured by the process according to the present invention.
Fig.7 is a sectional view that schematically illustrates one example of an electrostatic chuck manufactured by the process according to the present invention.
Fig. 8 is a horizontal sectional view that schematically illustrates a shape of an electrostatic electrode constituting an electrostatic chuck manufactured by the process according to the present invention.
Fig. 9 is a horizontal sectional view that schematically illustrates a shape of an electrostatic electrode constituting an electrostatic chuck manufactured by the process according to the present invention.
Fig. 10 is a sectional view that schematically illustrates the state that an electrostatic chuckmanufacturedby the process according to the present invention is fitted into a supporting case.
Fig. 11 is a partially enlarged sectional view that schematically illustrates a ceramic heater manufactured by the process according to the present invention.
Fig. 12 is a sectional view that schematically illustrates a conductor containing paste layer formed on a produced green sheet in a conventional process for manufacturing an electrostatic chuck.

### Explanation of symbols

- 1, 61: ceramic substrate
- 2, 22, 32a, 32b: chuck positive electrostatic layer
- 3, 23, 33a, 33b: chuck negative electrostatic layer
- 2a, 3a: semicircular part
- 2b, 3b: comb-teeth-shaped part
- 4: ceramic dielectric film
- 5, 12, 25, 62: resistance heating element
- 6, 18, 63: external terminal
- 7: metal wire
- 8: Peltier device
- 9: silicon wafer
- 20, 30, 101, 201, 301, 401: electrostatic chuck
- 16, 17, 69: conductor-filled through hole
- 25a: metal covering layer
- 35, 36: blind hole
- 41: supporting case
- 42: coolant outlet
- 43: inhalation duct
- 44: coolant inlet
- 45: heat insulator
- 50, 50': green sheet
- 51: printed body for an electrostatic electrode
- 52: printed body for a resistance heating element
- 53, 54: printed body for a conductor filled through hole
- 60: ceramic heater
- 61a: heating face
- 61b: bottom face
- 64: bottomed hole
- 65: through hole

### Detailed Disclosure of the Invention

A process for manufacturing an electrostatic chuck of the present invention comprises steps of:
printing a conductor containing paste for an electrode on a green sheet which has a surface roughness, Rmax, of 200 µm or less; forming a lamination by stacking another green sheet or.other green sheets on the above-mentioned green sheet; and then sintering the above-mentioned lamination.

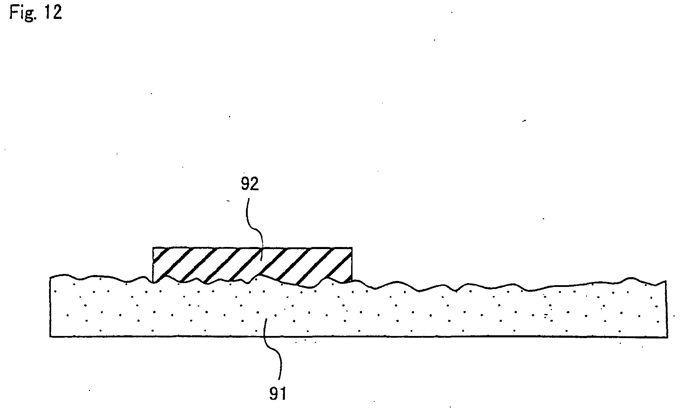

In the conventional process for manufacturing the electrostatic chuck, such a green sheet 91 having a large unevenness of the surface roughness, Rmax, exceeding 200 µm was used and a conductor containing paste layer 92 was occasionally formed on the green sheet 91 as shown in Fig. 12. In this case, the formed conductor containing paste layer 92 has a various thickness depending on place, therefore, resultantly, the produced electrostatic electrode of electrostatic chuck has unevenness in the thickness thereof.
As a result, a dispersion of chucking force depending on place was caused.

Also, unevenness was produced in a resistance heating element for a heater, thus, various calorific value depending on place were producing the temperature-differenceonthe heating face.

Such a tendency is especially significant in the disc-shaped body having a diameter exceeding 150mm. It is presumed that: at the time when JP Kokai Sho 62-264638 and JP Kokai Sho 60-261377 were filed, the market only demanded the one having a small diameter of about 150mm, hence, the dispersion of the chucking force and the temperature-difference of the heating face thereof hardly became problems.

However, in the present invention, since so much attention is paid on a surface roughness of the green sheet and thus relatively flat green sheet which has a surface roughness, Rmax, of 200µm or less is used, the conductor containing paste layer formed thereon has even thickness without a dispersion depending on place. Accordingly, the produced electrostatic electrode of the electrostatic chuck does not have unevenness on the thickness thereof so that the electrostatic chuck wherein an electrostatic electrode as a whole has even chucking force can be produced.

Also, the dispersion in the thickness of the resistance heating element can be made small so that the resistance value becomes constant, thus making the temperature difference on the heating face small as a whole.

The unevenness of the chucking force of the above-mentioned electrostatic chuck depending on place can be evaluated by measuring the surface temperature of the adsorbed semiconductor wafer by the thermoviewer. This is because: if the semiconductor wafer is adsorbed strongly to the adsorbing face of the electrostatic chuck, the temperature thereof becomes high and accordingly the dispersion of the chucking force is reflected on the temperature distribution.

Also, it is possible to measure the dispersion thereof by: putting a semiconductor wafer divided in a plurality of parts thereon; and measuring the adsorption force of each divided part by a load cell. In the Examples describedbelow, both the methods mentioned above were employed.

A surface roughness, Rmax, of a green sheet can be controlled either :by adjusting a particle diameter of the raw material ceramic powder to a given extent; by adjusting the viscosity of the composition for a green sheet to a given extent at the time of preparing thereof; or by selecting the drying condition. The condition for those is explained in detail in the part of an embodiment of the invention described below.

A process for manufacturing a ceramic heater of the present invention comprises steps of:
printing a conductor containing paste for a resistance heating element on a green sheet which has a surface roughness, Rmax, of 200 µm or less; forming a lamination by stacking another green sheet or other green sheets on the above-mentioned green sheet; and then sintering the above-mentioned lamination.

Accordingly, a resistance heating element produced by the above-mentioned process for a ceramic heater also has even thickness without dispersion depending on place, thus it generates even heat. Hence, the temperature of the face (heating face) of the ceramic heater for heating an object to be heated such as a semiconductor wafer becomes uniform so that an object to be heated can be heated evenly.

Similarly to the above-mentioned process for manufacturing an electrostatic chuck, a surface roughness Rmax of a green sheet can be controlled either : by adj usting a particle diameter of the raw material ceramic powder to a given extent; by adjusting the viscosity of the composition for a green sheet to a given extent at the time of preparing thereof ; or by selecting the drying condition.

Likewise, the unevenness of the calorific value of the above-mentioned resistance heating element depending on place can be evaluated by measuring the surface temperature of the semiconductor wafer placed on a heating face by the thermoviewer. This is because: the dispersion of calorific value depending on the portion is also reflected on the temperature-distribution of the heating face.

In this case, measurement can be done by observing the temperature distribution of the semiconductor wafer in the condition that disposing only resistance heating elements in the ceramic substrate.

A process for manufacturing an electrostatic chuck and a process for manufacturing a ceramic heater of the present invention are the same in that: in each process, after a green sheet is formed, a conductor containing paste is printed on the green sheet, then, after forming a lamination by stacking another green sheet or other green sheets on the thus produced green sheet which has a conductor containing paste layer, the lamination is sintered. And the difference only exists in the shape or the like of the conductor containing paste formed on the green sheet. Therefore, hereinafter, a process for manufacturing an electrostatic chuck is mainly explained and a process for manufacturing a ceramic heater is explained by complementing it.

A process for manufacturing an electrostatic chuck of the present invention comprises steps of:
printing a conductor containing paste for an electrode on a green sheet which has a surface roughness, Rmax of 200 µm or less; forming a lamination by stacking another green sheet or other green sheets on the above-mentioned green sheet; and then sintering the above-mentioned lamination.

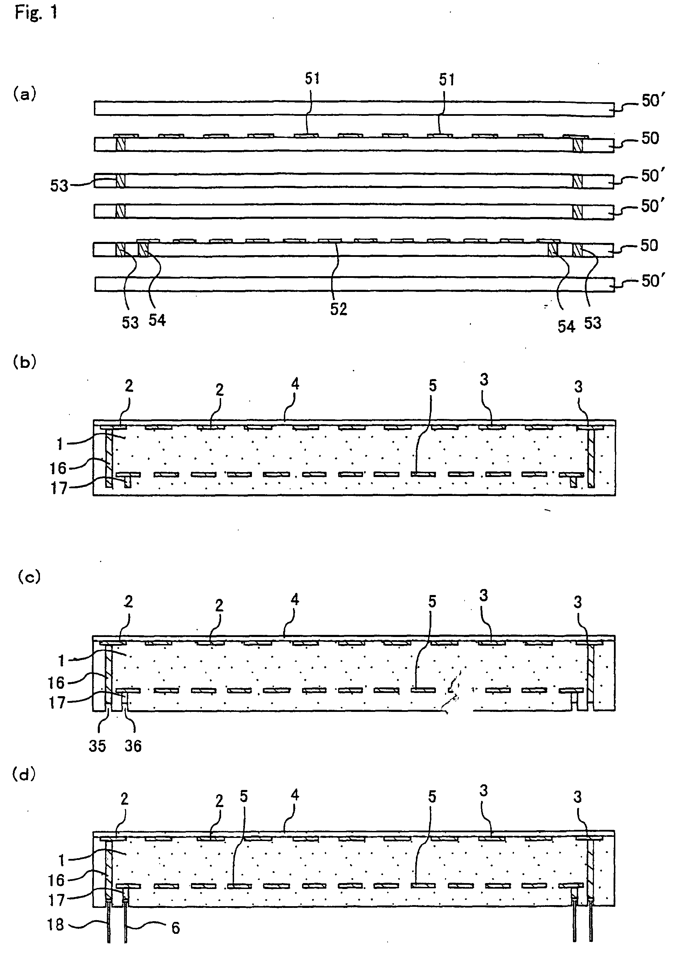

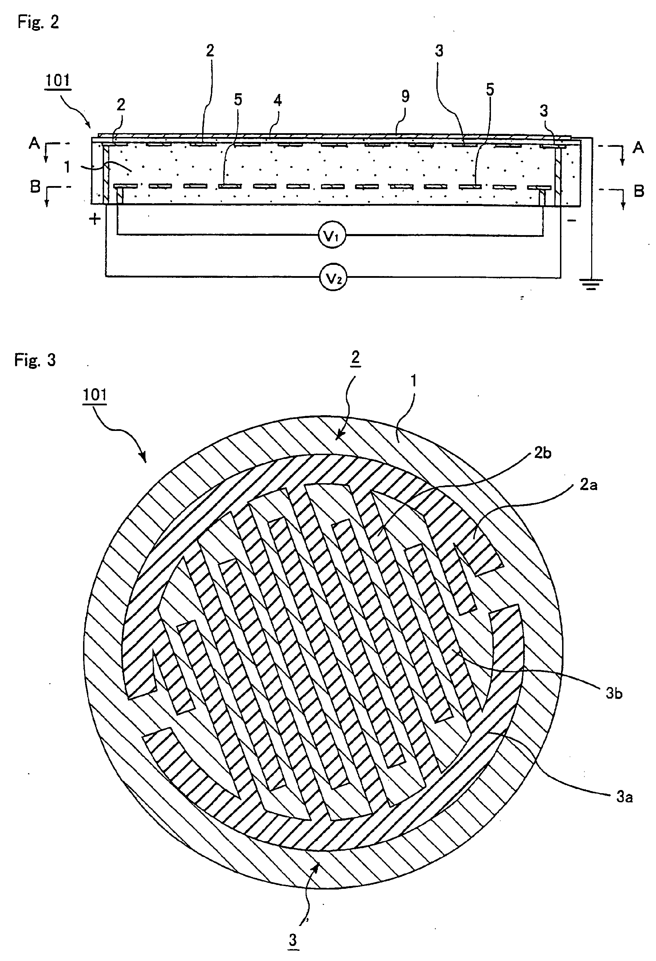

Fig.1 (a) to (d) are sectional views that schematically illustrate one example of a process for manufacturing an electrostatic chuck according to the present invention.
(1) In the present invention, firstly, by mixing raw material powder of ceramic such as a nitride ceramic or a carbide ceramic, with a binder and a solvent, a green sheet 50 having a surface roughness, as Rmax, of 200 µm or less is formed.
   The reason why the surface roughness of the green sheet is adjusted to be 200 µm or less is that: if the roughness, as Rmax, exceeds 200 µm, the surface of the green sheet is too coarse so that unevenness is formed on the portion of a conductor containing paste contacting with the green sheet, thus the thickness of an electrostatic electrode layerof themanufactured electrostatic chuck is dispersed depending on place, as a result of that, a chucking force thereof is also dispersed. Incidentally, needless to say the surface roughness Rmax of the green sheet does not exceed the thickness of the green sheet. Taking the strength of the green sheet into consideration, the surface roughness Rmax of the green sheet does not exceed 2/3 of the thickness of the green sheet. To be specific, the surface roughness Rmax of the green sheet is desirably 0.1µm or more and less than 50µm.
   The ceramic material constituting the electrostatic chuck which is an obj ect to be manufactured is not specifically limited and examples thereof include, for example, a nitride ceramic, a carbide ceramic, an oxide ceramic and the like.
   Examples of the above-mentioned nitride ceramic are metal nitride ceramic such as, for example, aluminum nitride, silicon nitride, boron nitride, and the like.
   Also, examples of the above-mentioned carbide ceramic are metal carbide ceramic such as, for example, silicon carbide, zirconium carbide, tantalum carbide, tungsten carbide, and the like.
   The examples of the above-mentioned oxide ceramic are a metal oxide ceramic such as alumina, zirconia, cordierite, mullite, beryllia and the like.
   These ceramics may be used either alone or in combination of two or more kinds of them.
   Among these ceramics, nitride ceramic and oxide ceramic are preferred.
   Aluminum nitride is most preferable among those nitride ceramics. That is because the produced ceramic substrate has the highest thermal conductivity of 180 W/m•K.
   The raw material powder of ceramic can be, for instance, aluminum nitride powder formed with a layer of an oxide on its surface by firing it in the oxidative atmosphere or the like.
   Also, based on the necessity, a sintering aid such as yttria, alumina and sulfur compounds, and a catalyst can be added. The average particle diameter of the material powder is preferably 0.1 to 5µm.
   Since several or one green sheet(s) 50' laminated on a green sheet on which an electrostatic electrode layer printed body 51 is formed become/becomes a layer to be the ceramic dielectric film 4, if necessary, it may have a composition different from that of the ceramic substrate.
   But, normally, as the raw materials of the ceramic dielectric film 4, it is preferable to use the same material as that of the ceramic substrate 1. That is because they are integrated and sintered together in many cases and thus, the firing conditions are the same. However, in case where the materials are different, it may be possible: to produce the ceramic substrate at first; and to form a conductor containing paste layer which is to be an electrostatic electrode layer thereon; then to form a green sheet which is to be a ceramic dielectric film further thereon; and finally to sinter it.
   As the binder, at least one selected from acrylic binder, ethyl cellulose, butyl cellosolve, polyvinyl alcohol is desirable.
   In addition, as the solvent, at least one selected from α-terpineol and glycol is desirable.
   The paste obtained by mixing them is formed to be a sheet-like shape by a forming method such as doctor blade method to produce the green sheet 50. At this time, the viscosity of the green sheet before drying is preferably 1×10⁴ to 4×10⁴ cP (10 to 40 Pa • s). By adjusting the viscosity of the green sheet in this extent, the unevenness on the green sheet becomes small, thus making the surface roughness, Rmax, to 200 µm or less.
   If the viscosity of the green sheet is less than 1×10⁴ cP (10 Pa • s), fluidity is too large to maintain the shape of the green sheet. Whereas, if the viscosity of the green sheet exceeds 4×10⁴ cP (40 Pa•s), it becomes difficult to flatten the surface of the green sheet by using a blade and the like, and in some cases, the surface roughness thereof, Rmax, exceeds 200 µm.
   The easiest method to adjust the surface roughness of the green sheet is to select the drying condition. In case that the viscosity of the green sheet is 1×10⁴ to 4×10⁴ cP (10 to 40 Pa • s), drying is conducted at 50 to 200 °C for 10 to 60 minutes. In this process, by setting the initial temperature for drying to less than 150°C, the surface roughness, Rmax, can be adjusted to 200 µm or less. Specifically, if the drying is conducted at high temperature, the solvent and the like existing inside volatilize rapidly thus making the surface thereof coarse, and if the drying is conducted at low temperature, the surface thereof becomes smooth. Incidentally, JP Kokai Hei 12-21961 specified a process of manufacturing an electrostatic chuck by green sheet method. But, the viscosity of the green sheet is not specified. Therefore, with such publications, patentability of the present invention can never be affected.
   Next, if necessary, the following may be provided in the green sheet 50: through holes for letting lifter pins of the silicon wafer pass through; a concave portion for embedding the thermocouple; and a part where the conductor-filled through holes are formed. The through holes can be formed by punching and the like.
   These through holes and concave portions and the like can be formed by drilling and the like, either: after forming a green sheet lamination; or after forming a sintered body.
   The preferable thickness of the green sheet 50 is approximately 0.1 to 5 mm.
   Next, the through holes of the green sheet 50 are filled with the conductor containing paste to obtain conductor-filled through hole printed bodies 53, 54 and then the conductor containing paste to be the electrostatic electrode layers and resistance heating elements are printed on the green sheet 50.
   The printing is carried out so as to obtain a desired aspect ratio in consideration of the shrinkage ratio of the green sheet 50, thereby obtaining an electrostatic electrode layer printed body 51 and a resistance heating element printed body 52.
   The printed bodies are formed by printing conductor containing pastes containing conductive ceramics, metal particles and the like. As the shape of the electrostatic electrode layer, the shapes illustrated on Fig. 3, Fig. 8 and Fig. 9 are listed. The resistance heating element will be explained later.
   As the conductive ceramic particles contained in these conductor containing pastes, a carbide of: tungsten; or molybdenum is optimum. That is because they are hardly oxidized and their thermal conductivity are hard to be lowered.
   Asthe metal particles,for example, tungsten, molybdenum, platinum, nickel and the like can be used.
   The average particle diameter of the conductive ceramic particles and the metal particles is preferably 0.1 to 5 µm. That is because the conductor containing paste is difficult to be printed if the size is too large or too small.
   As such a paste, the conductor containing paste produced by the following is optimum; mixing 85 to 97 parts by weight of metal particles or conductive ceramic particles, 1.5 to 10 parts by weight of at least one binder selected from an acrylic type binder, ethyl cellulose, butyl cellosolve, and polyvinyl alcohol, and 1.5 to 10 parts by weight of at least one solvent selected from α-terpineol, glycol, ethyl alcohol and butanol. In this case, the viscosity of the arranged conductor containing paste is preferably 5×10⁴ to 50×10⁴ cP (50 to 500 Pa • s).
   Next, as shown in Fig. 1(a), the green sheet 50 having the printed bodies 51, 52, 53, 54 and the green sheet 50' having no printed body are laminated. The reason why the green sheet 50' having no printed body is laminated on the resistance heating element formation side is to prevent the end surfaces of the conductor-filled through holes from being exposed and oxidized at the time of firing of the resistance heating element formation. If firing for the resistance heating elements formation is carried out with the end faces of the conductor-filled through holes exposed, it is required that the sputtering of non-oxidizable metal such as nickel is conducted. Also, covering with a gold brazing material of Au-Ni may be carried out.
(2) Next, as shown in Fig. 1(b), the lamination is heated and pressurized to form the lamination of the green sheets. The heating temperature of the lamination is preferably 50 to 300 °C and the pressure is preferably 20 to 200 kg /cm².
   Following this, the green sheets and the conductor containing pastes are sintered. The heating temperature at the firing is preferably 1000 to 2000 °C and the pressure at the firing is preferably 100 to 200 kg /cm². The heating and pressuring are carried out under the inert gas atmosphere. As the inert gas, argon, nitrogen and the like can be used. In the firing step, conductor-filled through holes 16, 17, the chuck positive electrostatic layer2,the chuck negative electrostatic layer 3, resistance heating elements 5 and the like are formed.
   After producing the ceramic substrate by the above-mentionedmethod, annealingcanbeconductedontheceramic substrate at 1400 to 2000 °C. By this procedure, impurities such as oxygen contained in grains of the crystal are discharged to the out of the crystal, and the thermal conductivity is improved.
(3) Next, as shown in Fig. 1(c), blind holes 35, 36 for external terminals connection are formed.
   Inner walls of the blind holes 35, 36 are preferably at least partially made conductive and the inner walls, thus made conductive, are preferably connected with the chuck positive electrostatic layer 2, the chuck negative electrostatic layer 3, resistance heating elements 5 and the like.
(4) Finally, as shown in Fig. 1(d), external terminals 6 , 18 are disposed in the blind holes 35, 36 through a gold brazing material. In addition, if necessary, a bottomed hole may be formed to bury a thermocouple inside thereof.

As a solder, alloys of silver-lead, lead-tin, bismuth-tin and the like can be used. Still more, the thickness of the solder layer is preferably 0.1 to 50 µm. That is because this range is sufficient to keep the connection by the solder.

By adopting such a manufacturing process, for instance, an electrostatic chuck illustrated in Figs.2,3 can be produced. The electrostatic electrode layer of the obtained electrostatic chuck does not have thickness dispersion so that an electrostatic chuck has even chucking force as a whole.

Fig. 2 is a vertical sectional view that schematically illustrates one embodiment of an electrostatic chuck manufactured by the above-mentioned process. Fig. 3 is a sectional view taken along the A-A line of the electrostatic chuck shown in Fig. 1. Fig. 3 is a sectional view taken along the B-B line of the electrostatic chuck shown in Fig. 2.

In this electrostatic chuck 101, an electrostatic electrode layer composed of a chuck positive electrostatic layer 2 and a chuck negative electrostatic layer 3 is formed inside a ceramic substrate 1 in a circular shape. A thin ceramic layer 4 (hereinafter, referred to as a ceramic dielectric film) is formed on this electrostatic electrode layer. Also, a silicon wafer 9 is placed on the electrostatic chuck 101 and is earthed.

As shown in Fig. 3, the chuck positive electrostatic layer 2 is composed of a semicircular arc part 2a and a comb-teeth-shaped part 2b. The chuck negative electrostatic layer 3 is also composed of a semicircular arc part 3a and a comb-teeth-shaped part-3b. These chuck positive electrostatic layer 2 and chuck negative electrostatic layer 3 are arranged face-to-face in such a manner that the teeth of one comb-teeth-shaped part 2b extend in staggered relation with the teeth of the other comb-teeth-shaped part 3b. The + side and the - side of a direct current power source are connected to the chuck positive electrostatic layer 2 and chuck negative electrostatic layer 3, respectively. Thus, a direct current V₂ is to be applied thereto.

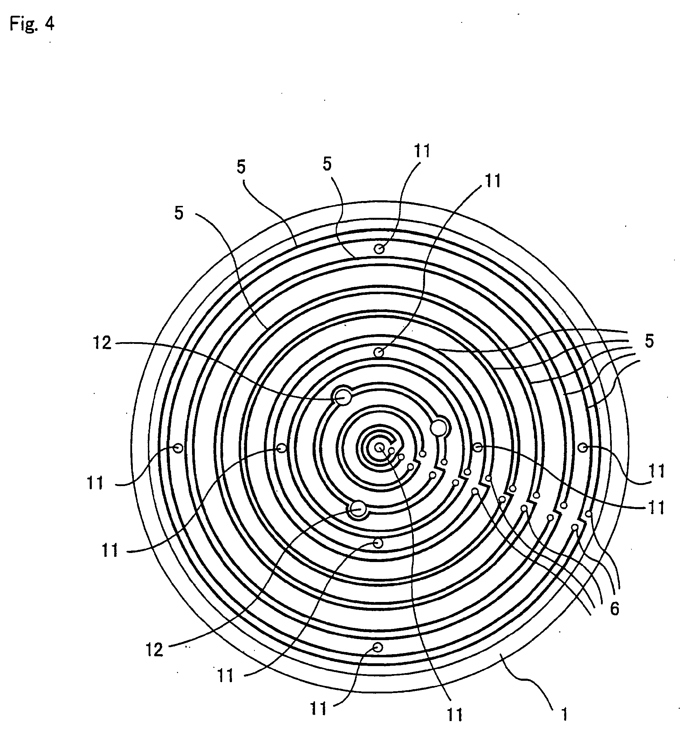

In order to control the temperature of the silicon wafer 9 , resistance heating elements 5 in the form of concentric circles as viewed from the above, as shown in Fig. 4, are set up inside the ceramic substrate 1. External terminals 6 are connected and fixed to both ends of the resistance heating elements 5, and a voltage V₁ is to be applied thereto. Bottomed holes 11 for inserting temperature-measuring elements and through holes 12 for letting lifter pins (not illustrated) that support the silicon wafer 9 and move it up and down pass through are formed in the ceramic substrate 1, as shown in Fig. 4 but not shown in Figs. 2. Incidentally, the resistance heating elements 5 may be formed on the bottom face of the ceramic substrate 1.

When this electrostatic chuck 101 is caused to function, a direct voltage V₂ is applied to the chuck positive electrostatic layer 2 and the chuck negative electrostatic layer 3. In this way, the silicon wafer 9 is adsorbed and fixed to the chuck positive electrostatic layer 2 and the chuck negative electrostatic layer 3 through the ceramic dielectric film 4 by electrostatic action of these electrodes. The silicon wafer 9 is fixed onto the electrostatic chuck 101 in this way, and subsequently the silicon wafer 9 is subjected to various treatments such as CVD and the like.

Next, a ceramic substrate constituting an electrostatic chuck manufactured by the above-mentioned process will be explained. The ceramic substrate means the parts other than ceramic dielectric film, in this electrostatic chuck.

The above-mentioned electrostatic chuck is preferably used at 150 °C or higher, most preferably at 200 °C or higher.

In the above-mentioned ceramic substrate, it is desirable that the pore diameter of the maximum pore is 50 µm or less and the porosity thereof is 5% or less. Also, in the above-mentioned ceramic substrate, it is desirable that there are no pores, or even if there are pores, the pore diameter of the largest pore is 50 µm or less.

If there are no pores, breakdown voltage at high temperature becomes particularly high. To the contrary, if the pores exist to some extent, fracture toughness value becomes higher. Hence, which design to take will be decided based on the required characteristics.

The reason why fracture toughness value is improved by the existence of the pores is not clear. However, it is presumed that the development of the cracks is stopped by the pores.

The reason why the pore diameter of the maximum pore is desirably 50 µm or less is that: if the pore diameter is over 50 µm, high breakdown voltage property cannot be ensured at a high temperature, particularly at 200 °C or higher.

The pore diameter of the maximum pore is desirably 10 µm or less. This is because a degree of a warp at 200 °C or higher becomes small.

The porosity and the pore diameter of the maximum pore can be adjusted by pressing time, pressure, temperature at the time of sintering, and additives such as SiC and BN. As mentioned above, since SiC and BN obstruct sintering, pores can be introduced by them.

At the measurement of the pore diameter of the maximum pore, 5 samples are prepared. The surfaces thereof are ground into mirror planes. With an electron microscope, ten points on the surface are photographed with 2000 to 5000 magnifications. The maximum pore diameters are selected from the photographs obtained by the photographing, and the average of the 50 shots is defined as the pore diameter of the maximum pore.

The porosity is measured by Archimedes' method. According to this method, a sintered body is crushed into pieces, and the crushed pieces are put into an organic solvent or mercury to measure the volume thereof. Then the true specific gravity of the pieces is obtained from the weight and the measured volume thereof, and the porosity is calculated from the true specific gravity and apparent specific gravity.

The diameter of the above-mentioned ceramic substrate desirably exceeds 150mm, and is more desirably 200 mm or more. It is particularly desirable that the diameter is 12 inches (300 mm) or more.

This is because in a large substrate having a diameter exceeding 150mm, the dispersion of the temperature of a heated semiconductor wafer will be large attributed to the dispersion of the chucking force. Also, the thermal capacity of the ceramic substrate becomes large and the temperature of the heating face becomes uneven. To say conversely, in a ceramic substrate with diameter of some 150mm, even though chucking force is dispersed to some extent, the surface temperature becomes even, since the semiconductor wafer is also small. Further, if the resistance value of the resistance heating element is dispersed to some extent, the temperature thereof easily rises and tend to be relatively even, since the thermal capacity of the ceramic substrate is small.

Incidentally, in the example of the publication of JP Kokai Hei 11-74064, the ceramic substrate having a diameter of 300mm is disclosed. However, the electrode is not the one formed by performing printing on the green sheet, hence the existence of such a reference never affect the patentability of the present invention.

The thickness of the above-mentioned ceramic substrate is desirably 50 mm or less, and particularly desirably 25 mm or less.

If the thickness of the ceramic substrate is over 25 mm, the thermal capacity of the ceramic substrate may be too large in some cases. Particularly when a temperature controlling means is set up to heat or cool the substrate, temperature-following property may become poor due to the large thermal capacity.

The thickness of the ceramic substrate is optimally exceeding 1.5mm, and 5 mm or less.

In cases that the thickness of the substrate is 1.5mm or less, the large ceramic substrate with a diameter exceeding 150 mm causes a large degree of amount of warp and thus not practical.

The above-mentioned ceramic substrate desirably contains oxygen in an amount of 0.05 to 10% by weight. This is because, by segregating oxygen to grain boundary, it becomes possible to improve fracture toughness value.

If the oxygen content is below 0.05% by weight, the sintering does not proceed enough and thus porosity becomes high and thermal conductivity becomes low. To the contrary, if the oxygen content exceeds 10% by weight, the amount of oxygen in grain boundaries becomes too large and thus thermal conductivity drops with a consequent deterioration of the temperature-rising and temperature-dropping property.

In order to incorporate oxygen in the above-mentioned ceramic substrate, as mentioned above, the firing of the material powder is conducted in oxidative atmosphere or a metal oxide may be added in the material powder.

Examples of the above-mentionedmetal oxide include yttria (Y₂O₃), alumina (Al₂O₃) , rubidium oxide (Rb₂O), lithium oxide (Li₂O), calcium oxide (CaCO₃) and the like.

The content of these metal oxides is preferably 0.1 to 20 % by weight.

In the present invention, the ceramic substrate desirably contains 5 to 5000 ppm of carbon.

The ceramic substrate can be blackened by incorporating carbon and thus, when the substrate is used as a heater, radiant heat can be sufficiently used.

Carbon may be amorphous or crystalline. When amorphous carbon is used, a drop in the volume resistivity at high temperature can be prevented. And when crystalline carbon is used, a drop in the thermal conductivity at high temperature can be prevented. Therefore, crystalline carbon and amorphous carbon may be used together dependently on the purpose. The carbon content is preferably from 50 to 2000 ppm.

When carbon is contained in the ceramic substrate, carbon is preferably contained in the manner that its brightness will be N6 or less as a value based on the rule of JIS Z 8721. The ceramic having such brightness is superior in radiant heat capacity and concealing property.

The brightness N is defined as follows: the brightness of ideal black is made to 0; that of ideal white is made to 10; respective colors are divided into 10 parts in the manner that the brightness of the respective colors is recognized stepwise between the brightness of black and that of white at equal intensity intervals; and the resultant parts are indicated by symbols N0 to N10, respectively.

Actual brightness is measured by comparison with color chips corresponding to N0 to N10. One place of decimals in this case is made to 0 or 5.

The material of the ceramic dielectric film constituting the above-mentioned electrostatic chuck is not especially limited, and examples thereof include a nitride ceramic, a carbide ceramic, an oxide ceramic, and the like. Among them, a nitride ceramic is most preferable.

As the above-mentioned nitride ceramic, the same as the above-mentioned ceramic substrate can be listed. However, it is preferable that a nitride ceramic is containing oxygen.

For example, raw material powder of the nitride ceramic is heated in an oxidative atmosphere or in the air, or the raw material powder of the nitride ceramic is mixed with a metal oxide and then the mixture is sintered, in order to incorporate oxygen into the above-mentioned nitride ceramic.

Examples of the above-mentioned metal oxide include alumina (Al₂O₃), silicon oxide (SiO₂), and the like.

The amount to be added of these metal oxides is preferably 0.1 to 10 parts by weight per 100 parts by weight of the nitride ceramic.

By adjusting the thickness of the ceramic dielectric film to 50 to 5000 µm, sufficient breakdown voltage can be secured without lowering chucking force.

If the thickness of the above-mentioned ceramic dielectric film is below 50 µm, the film thickness is too thin to obtain sufficient breakdown voltage. Thus, when a silicon wafer is placed on the film and is adsorbed thereon, the ceramic dielectric film may undergo dielectric breakdown. On the other hand, if the thickness of the above-mentioned ceramic dielectric film is over 5000 µm, the distance between the silicon wafer and the electrostatic electrodes becomes large so that the capability of adsorbing the silicon wafer becomes poor. The thickness of the ceramic dielectric film is preferably 100 to 1500 µm.

In the electrostatic chuck 101, the ceramic dielectric film 4 is made of a nitride ceramic containing oxygen. Also, it is desirable that its porosity is 5% or less, and the pore diameter of its maximum pore is 50 µm or less. Also, the pores in this dielectric film 4 are preferably composed of pores independent each other.

In the ceramic dielectric film 4 having such a constitution, it does not happen that gas and the like which cause a drop in the breakdown voltage penetrate through the ceramic dielectric film to corrode the electrostatic electrode and lower the breakdown voltage of the ceramic dielectric film even at high temperature.

If the above-mentioned porosity is over 5%, the number of the pores increases and the pore diameter becomes too large. As a result, the pores interconnect easily with each other. In the ceramic dielectric film having such a structure, the breakdown voltage drops.

If the pore diameter of the maximum pore is over 50 µm, the sufficient breakdown voltage cannot be maintained at high temperature even if the oxide is present in the boundaries between the particles. In the case that the pores are present, the porosity is more preferably 0.01 to 3% and the pore diameter of the maximum pore is more preferably 0.1 to 10 µm.

The ceramic dielectric film desirably contains 50 to 5000 ppm of carbon. This is because the electrode pattern set inside the electrostatic chuck can be concealed and high radiant heat can be obtained. Also, the volume resistivity becomes lower, the capability of adsorbing a silicon wafer becomes high at low temperature.

The reason why in the electrostatic chuck of the present invention a considerable number of the pores may be present in the ceramic dielectric film is that the pores can cause an improvement in the fracture toughness value and the resistance to thermal impact.

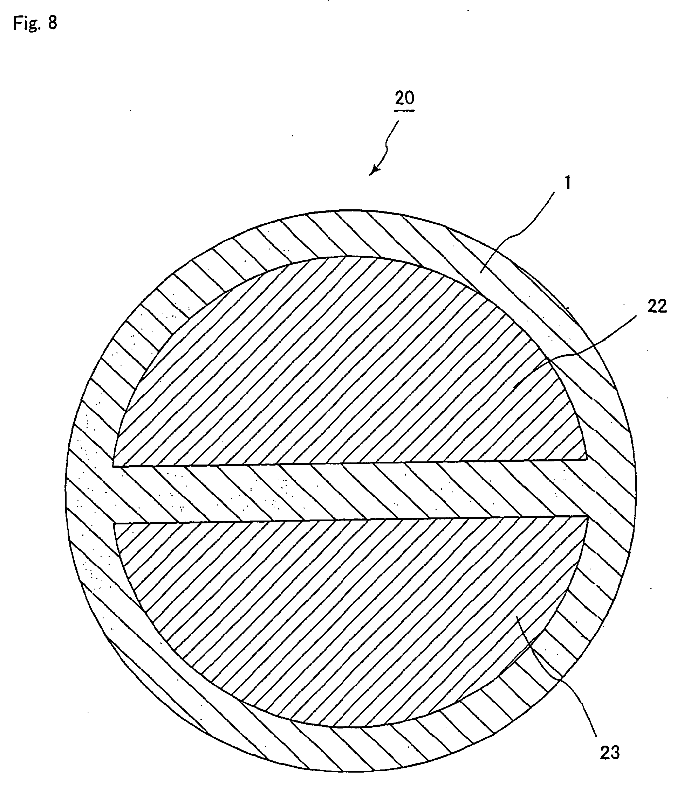

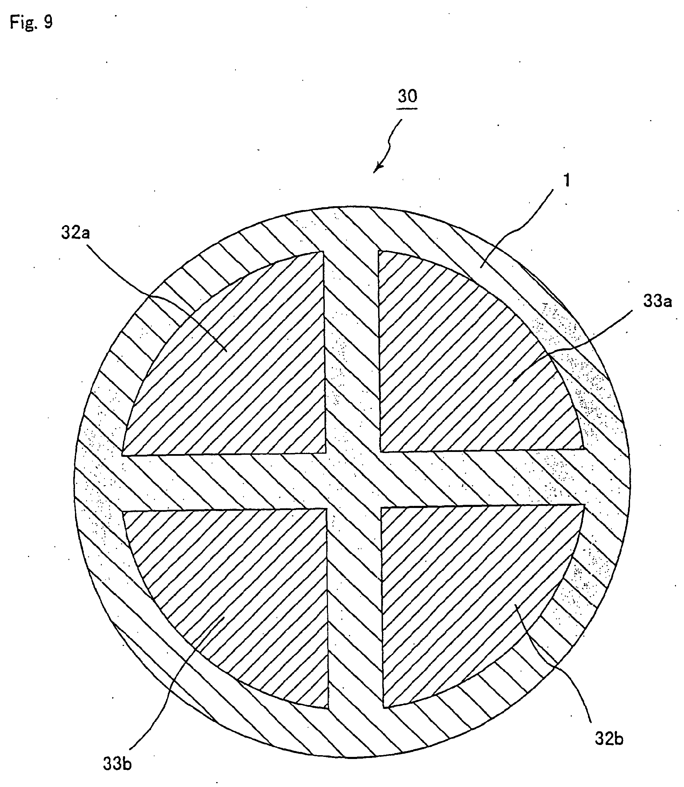

Figs. 8, 9 are horizontal sectional views, each of which schematically shows an electrostatic electrode in another electrostatic chuck. In an electrostatic chuck 20 shown in Fig. 8, a chuck positive electrostatic layer 22 and a chuck negative electrostatic layer 23 in a semicircular shape are formed inside a ceramic substrate 1. In an electrostatic chuck shown in Fig. 9, chuck positive electrostatic layers 32a and 32b and chuck negative electrostatic layers 33a and 33b, each of which has a shape obtained by dividing a circle into 4 parts, are formed inside a ceramic substrate 1. The two chuck positive electrostatic layers 22a, 22b and the two chuck negative electrostatic layers 33a, 33b are formed to cross, respectively.

In the case that an electrode having a form that an electrode in the shape of a circle or the like is divided is formed, the number of divided pieces is not particularly limited and may be 5 or more. Its shape is not limited to a sector, either.

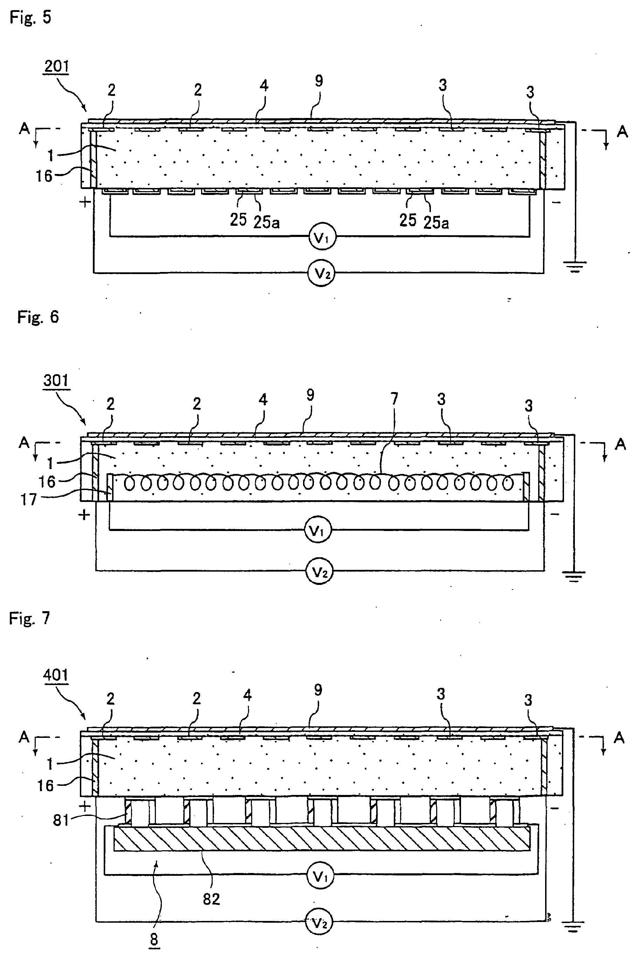

Examples of the electrostatic chuck according to the present invention include: the electrostatic chuck 101 having a structure wherein the chuck positive electrostatic layer 2 and the chuck negative electrostatic layer 3 are arranged between the ceramic substrate 1 and the ceramic dielectric film 4 and the resistance heating elements 5 are set up inside the ceramic substrate 1, as shown in Fig. 2; the electrostatic chuck 201 havinga structure wherein the chuckpositive electrostatic layer 2 and the chuck negative electrostatic layer 3 are arranged between the ceramic substrate 1 and the ceramic dielectric film 4 and the resistance heating elements 25 are disposed on the bottom face of the ceramic substrate 1, as shown in Fig. 5; the electrostatic chuck 301 having a structure wherein the chuck positive electrostatic layer 2 and the chuck negative electrostatic layer 3 are arranged between the ceramic substrate 1 and the ceramic dielectric film 4 and the metal wire 7, which is a resistance heating element, is embedded in the ceramic substrate 1, as shown in Fig. 6; and the electrostatic chuck 401 having a structure wherein the chuck positive electrostatic layer 2 and the chuck negative electrostatic layer 3 are arranged between the ceramic substrate 1 and the ceramic dielectric film 4 and the Peltier device 8 composed of the thermoelectric element 81 and the ceramic plate 82 is formed on the bottom face of the ceramic substrate 1, as shown in Fig. 7.

As the electrostatic chuck shown in Fig. 7, in the case that the Peltier device is used as the temperature controlling means, both heating and cooling can be attained by changing the direction along which an electric current passes. Thus, this case is advantageous.

The Peltier device 8 is formed by connecting p type and n type thermoelectric elements 81 in series and then jointing the resultant to a ceramic plate 82 and the like.

Examples of the Peltier device include silicon/germanium, bismuth/antimony, lead/tellurium type materials, and the like.

As shown in Figs. 2 to 7, in the above-mentioned electrostatic chuck, the chuck positive electrostatic layer 2 and the chuck negative electrostatic layer 3 are arranged between the ceramic substrate 1 and the ceramic dielectric film 4 and the resistance heating element 5 or the metal wire 7 is formed inside the ceramic substrate 1. Therefore, connecting units (conductor-filled through holes) 16,17 are necessary for connecting these to external terminals.

The conductor-filled through holes 16,17 are made by filling there with a high melting point metal such as tungsten paste or molybdenum paste, or a conductive ceramic such as tungsten carbide or molybdenum carbide.

The diameter of the connecting portions (conductor-filled through holes) 16,17 is desirably from 0.1 to 10 mm. This is because disconnection can be prevented and further cracks or strains can be prevented.

The conductor-filled through holes are used as connecting pads to connect with external terminals 6,18 (reference to Fig. 1(d)).

The connecting thereof is performed with solder or brazing material. As the brazing material, brazing silver, brazing palladium, brazing aluminum, or brazing gold is used. Brazing gold is desirably Au-Ni alloy. This is because Au-Ni alloy is superior in adhesiveness to tungsten.

The ratio of Au/Ni is desirably [81.5 to 82.5 (% by weight)]/[18.5 to 17.5 (% by weight)].

The thickness of the Au-Ni layer is desirably from 0.1 to 50 µm. This is because this range is sufficient for securing connection. If Au-Cu alloy is used at a high temperature of 500 to 1000 °C and at a high vacuum of 10⁻⁶ to 10⁻⁵ Pa, the Au-Cu alloy deteriorates. However, Au-Ni alloy does not cause such deterioration and is profitable. Also, when the total amount of the Au-Ni alloy is regarded as 100 parts by weight, the amount of impurities therein is desirably below 1 part by weight.

If necessary, in the present invention a thermocouple may be buried in the bottomed hole in the ceramic substrate. This is because the thermocouple makes it possible to measure the temperature of the resistance heating element and, on the basis of the resultant data, voltage or electric current is changed so that the temperature can be controlled.

The size of the connecting portion of metal wires of the thermocouple is desirably the same as the strand diameter of the respective metal wires or larger, and is preferably 0.5 mm or less. Such a structure makes the thermal capacity of the connecting portion small, and causes a temperature to be correctly and rapidly converted to a current value. For this reason, temperature controllability is improved so that the temperature distribution of the heated surface of the semiconductor wafer becomes small.

Examples of the above-mentioned thermocouple include K, R, B, S, E, J and T type thermocouples, described in JIS-C-1602 (1980).

In the above-mentioned manufacturing method of an electrostatic chuck, the electrostatic chuck 101 (reference to Fig. 2, 3) is given as an example. In the case that the electrostatic chuck 201 (reference to Fig. 5) is produced, it is advisable to: produce a ceramic substrate having an electrostatic electrode layer first; then print a conductor containing paste on the bottom face of this ceramic substrate and sinter the resultant to form the resistance heating elements 25; and then form the metal covering layer 25a by electroless plating and the like. In the case that the electrostatic chuck 301 (reference to Fig. 6) is produced, it is advisable that: firstly, a metal wire is placed on the green sheet instead of forming a conductor containing paste layer which is to be a resistance heating element, and other than that, almost the same process as in the case of the electrostatic chuck 101 can be adopted.

Further, in the case that the electrostatic chuck 401 (reference to Fig. 7) is produced, it is advisable that: firstly a ceramic substrate having an electrostatic electrode layer is produced; and then a Peltier device is jointed to this ceramic substrate through a flame sprayed metal layer.

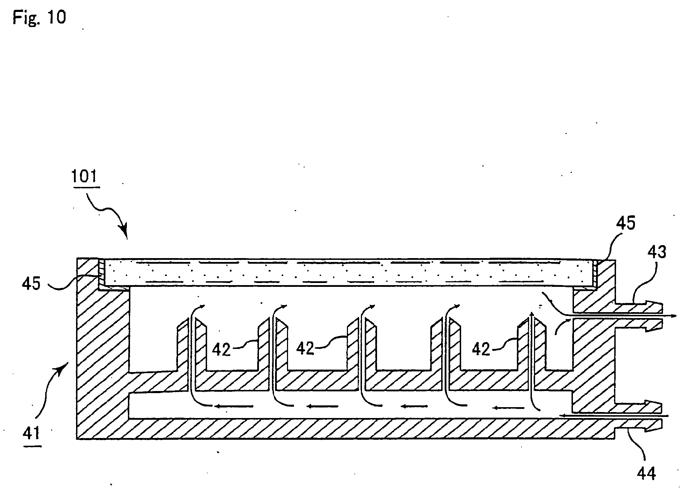

Fig. 10 is a sectional view that schematically shows a supporting case 41 into which the electrostatic chuck of the present invention, having a structure as described above, is fitted.

The electrostatic chuck 101 is to be fitted into the supporting case 41 through a heat insulator 45. Coolant outlets 42 are formed in the supporting case 11, and a coolant is blown from a coolant inlet 44 and goes outside from an inhalation duct 43 after passing through the coolant outlet 42. By the act of this coolant, the electrostatic chuck 101 can be cooled.

Next, the following will describe a process for producing a ceramic heater according to the present invention.

A process for manufacturing a ceramic heater of the present invention comprises steps of:
printing a conductor containing paste for a resistance heating element on a green sheet which has a surface roughness, Rmax, of 200 µm or less; forming a lamination by stacking another green sheet or other green sheets on the above-mentioned green sheet; and then sintering the above-mentioned lamination.

In the present invention, other than the part of printing a conductor containing paste for a resistance heating element on a green sheet, a ceramic heater comprising a resistance heating element inside thereof is manufactured by almost the same process as the above-mentioned process for manufacturing an electrostatic chuck. Accordingly, herein, only the part of a process for forming a resistance heating element will be described.

The resistance heating element is preferably made of a metal, such as noble metals (gold, silver, platinum, palladium) , tungsten, molybdenum, nickel, and the like, or a conductive ceramic such as tungsten carbide and molybdenum carbide. With these materials, the resistance value can become large and also, the thickness itself can be increased to prevent disconnection and the like. Moreover, these materials are not easily oxidized and drop in thermal conductivity thereof can be avoided. These materials may be used independently or two or more of them may be used in a combination.

Also, since the temperature of the ceramic substrate must be made even throughout, the resistance heating element is preferably in a pattern of concentric circles, such as shown in Fig. 4 , or a combination of such a concentric circular pattern and a winding line or the like pattern. The thickness of the obtained resistance heating element in the ceramic heater is preferably adjusted to be 1 to 50 µm and the width of the element is preferably adjusted to be 5 to 20 mm.

While the resistance value can be adjusted by varying the thickness and width of the resistance heating element, the above-mentioned ranges are most practical. The resistance value of the resistance heating element is increased as the element becomes thinner and narrower.

Incidentally, when the resistance heating element is internally disposed, the distance between the heating face and the resistance heating element is decreased so that the temperature evenness of the surface deteriorates. Therefore, the width of the resistance heating element itself must be increased. Moreover, since the resistance heating element is disposed inside the ceramic substrate, the adhesion with the ceramic substrate can be disregarded.

The sectional configuration of the resistance heating element may be orthogonal, elliptical, spindle-shaped or dome-shaped but the element is preferably in a flat shape. This is because the flat shape contributes to an efficient radiation of heat toward the heating face with a consequent increase of the transfer of heat to the heating face, thus minimizing the temperature distribution on the heating face. The resistance heating element may also have a spiral pattern.

When the resistance heating element formed inside the ceramic substrate, the resistance heating element is preferably formed within the region up to 60% from the bottom face in the thickness direction. The rationale of doing so is to prevent the formation of a temperature distribution on the heating face so that the semiconductor wafer may be evenly heated.

In a manufacturing method of the ceramic heater of the present invention, the resistance heating element is formed inside the ceramic substrate. However, in the above-mentioned manufacturing method of the electrostatic chuck, the resistance heating element may be formed on a bottom face of the ceramic substrate. Accordingly, herein, the case of forming the resistance heating element on a bottom face of the ceramic substrate will be described together.

In the case where the resistance heating element is formed on a bottom face of the ceramic substrate, usually, after the ceramic substrate is manufactured by sintering, the above-mentioned conductor containing paste layer is formed on the surface, and then the resultant is sintered to form the resistance heating element.

The conductor containing paste used: when forming a conductor containing paste on the bottom face of the ceramic substrate; or when forming a conductor containing paste layer on the surface of the green sheet is not particularly restricted but preferably contains a resin, solvent, thickener and other components in addition to a metal particle or a conductive ceramic particle which are for maintaining conductivity.

The metal particle and conductive ceramic particle mentioned above may be the materials mentioned hereinbefore. The preferred particle diameter of these metal particle or conductive ceramic particle is 0.1 to 100 µm. When the particle is too fine, that is to say less than 0.1 µm in particle diameter, they are liable to be oxidized. On the other hand, particles over 100 µm in diameter cannot be easily sintered, and has a high resistance value.

The shape of the above-mentioned metal particle may be spherical or scaly. When these metal particles are used, it may be a mixture of spherical particles and scaly particles mentioned above.

When the above-mentioned metal particle is scaly or a mixture of spherical and scaly particles, the metal oxide is more securely supported between the metal particles with the consequent advantage that a better adhesion is established between the resistance heating element and the ceramic substrate and, at the same time, an increased resistance value can be obtained.

The resin which can be used in the above-mentioned conductor containing pasteincludes,for example,acrylic resin, epoxy resin and phenolic resin. The solvent may for example be isopropyl alcohol and the like. The thickener mentioned above may for example be a cellulose and the like.

When the resistance heating element is formed inside the ceramic substrate, the conductor containing paste preferable has a viscosity of 5×10⁴ to 50×10⁴ cP (50 to 500 Pa•s).

When the conductor containing paste for the resistance heating element is to be formed on the surface of the ceramic substrate, it is preferable to add a metal oxide, in addition to the above-mentioned metal particle, in the above-mentioned conductor containing paste and sinter the metal particle and metal oxide particle. When the metal oxide and the metal particle are cosintered in this manner, a better adhesion can be assured between the ceramic substrate and the metal particle.

The reason why the incorporation of the above-mentioned metal oxide improves the adhesion to the ceramic substrate is not fully clear but it is suspected to be as follows. That is, the surface of the metal particle and that of the non-oxide ceramic substrate have both been slightly oxidized and are covered with an oxidized f ilm and these oxidized films are integrated together through the incorporated metal oxide on sintering to give an intimate bond between the metal particle and the ceramic. When the ceramic constituting the ceramic substrate is an oxide, its surface layer is of course composed of the oxide, thus a conductor layer with good adhesion is formed.

The above-mentioned metal oxide is preferably at least one selected from the group consisting of lead oxide, zinc oxide, silica, boron oxide (B₂O₃), alumina, yttria and titania.

This is because: these oxides are capable of improving the adhesion between the metal particle and the ceramic substrate without increasing the resistance value of the resistance heating element.

Their amounts are preferred to be adjusted: in the proportion, in weight parts, of lead oxide, zinc oxide, silica, boron oxide (B₂O₃), alumina, yttria and titania based on 100 weight parts of the total metal oxide is lead oxide 1 to 10, silica 1 to 30, boron oxide 5 to 50, zinc oxide 20 to 70, alumina 1 to 10, yttria 1 to 50, and titania 1 to 50, the total being not over 100 weight parts.

By adjusting the amounts of such oxides within the above ranges, particularly the adhesion to the ceramic substrate can be improved.

The level of addition of the above-mentioned metal oxide to metal particle is preferably 0.1 or more weight % and less than 10 weight %. The area resistivity of the resistance heating element formed by using such a conductor containing paste is preferably 1 to 45 mΩ/□.

When the area resistivity exceeds 45 mΩ/□, the amount of heat generation becomes too large relative to the applied voltage value so that in the case of a ceramic substrate for a semiconductor device having a resistance heating element on its surface, the amount of heat generation cannot be easily controlled. When the level of addition of the metal oxide is 10 weight % or higher, the area resistivity exceeds 50 mΩ/□, with the result that the amount of heat generated will become so large as to make temperature control difficult, and thus lower the evenness of a temperature distribution.

When the resistance heating element is formed on the surface of the ceramic substrate, it is preferable that a metal covering layer be formed on the surface of the resistance heating element to prevent oxidation of the inner metal sintered body and consequent change in resistance value. The preferred thickness of such a metal covering layer is 0.1 to 10 µm.

The metal for use in forming the above-mentioned metal covering layer is not particularly restricted provided that it is a metal which is non-oxidizable. Specifically, for example, gold, silver, palladium, platinum, nickel, etc. canbementioned. These metals can be used alone or two or more of them may be used in a combination. The preferred, among said metals, is nickel.

When the resistance heating element is formed inside the ceramic substrate, this covering is not required because the surface of the resistance heating element is not subjected to oxidation.

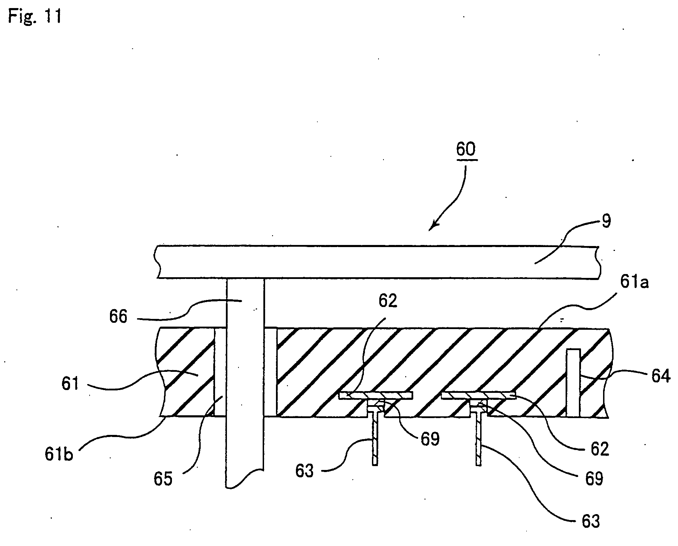

The resistance heating element produced in the above-mentioned method is for instance in a concentric shape as the resistance heating element formed in an electrostatic chuck shown in Fig. 4. Fig. 11 is a partially enlarged sectional view that shows a part of this ceramic heater.

The ceramic substrate 61 is formed to be a circular shape and resistance heating elements 62 in concentric circular patterns are formed inside the ceramic substrate 61. These resistance heating elements 62 are connected in the manner that two concentric circles near to each other, as a pair, are connected to produce one line. Each external terminal 63 to be the input and output terminals is connected to both end parts of the respective circuits through conductor-filled through holes 69.

Further, as shown in Fig. 11, through holes 65 are formed in the ceramic substrate 61 and supporting pins 66 are inserted into the through holes 65 to hold a silicon wafer 9.

By moving the supporting pins 66 up and down, it is possible: to receive the silicon wafer 9 from a carrier machine; to place the silicon wafer 9 on a heating face 61a of the ceramic substrate 61; or to heat the silicon wafer 9 while supporting it in the state that a constant interval is kept between the silicon wafer 9 and the wafer treatment surface 61a.

In addition, bottomed holes 64 are formed in a bottom face 61a of the ceramic substrate 61 to insert a temperature measurement element such as a thermocouple and the like. When the resistance heating elements 62 is energized, the ceramic substrate 61 is heated, thereby heating an object to be heated such as the silicon wafer. Since a resistance heating element having an even thickness without dispersion depending on place is formed on the ceramic heater obtained by using a process of the present invention, an object to be heated such as the semiconductor wafer can be heated evenly.

If the resistance heating elements are provided inside the ceramic substrate, as shown in Fig. 10, an inlet for blowing a coolant such as air as a cooling mean may be formed in the supporting case which fits the ceramic substrate. If the resistance heating elements are provided inside the ceramic substrate, they may be provided in a plurality of layers. In this case, it is desirable that the patterns of the respective layers may be formed to complement them mutually. The pattern, when being viewed from the heating face, is desirably formed on any one of the layers. For example, a structure having a staggered arrangement is desirable.

The ceramic heater of the present invention may function as a wafer prober if: a chuck top conductor layer is provided on the surface thereof; and a guard electrode and a ground electrode are formed inside thereof. The ceramic heater of the present invention may also function as an electrostatic chuck if: an electrostatic electrode is formed.

The ceramic heater can heat a semiconductor wafer either: in the state that a semiconductor wafer is directly placed thereon; or in the state that a gap of approximately 50 to 2 , 000 µm is kept therebetween.

### Best Modes for Carrying Out the Invention

The present invention will be described in more detailed hereinafter.

### (Example 1) Production of an electrostatic chuck (reference to Fig. 1)

(1) A green sheet of 0.47 mm-thickness was obtained by: preparing a paste with a viscosity of 20000 cP produced by mixing 1 , 000 parts by weight of an aluminum nitride powder (the average particle diameter of 0.6 µm, produced by Tokuyama Corp.), 40 parts by weight of yttria (the average particle diameter of 0.4 µm) , 115 parts by weight of an acrylic binder, 5 parts by weight of a dispersant, and 530 parts by weight of alcohol containing 1-butanol and ethanol; and forming the paste by doctor blade method followed by drying in the condition listed in Table1. Incidentally, regarding the drying condition listed in Table1, after the drying is conducted with the condition in the first row, the drying is conducted again with the condition in the second row.
(2) Next, the green sheet was dried at 80 °C for 5 hours and then, parts to be through holes having a diameter of 1.8 mm, 3.0 mm and 5.0 mm for letting semiconductor wafer lifter pins pass through; and parts to be conductor-filled through holes for connecting the external terminals were formed by punching.
(3) A conductor containing paste A was prepared by mixing 100 parts by weight of tungsten carbide particle having the average particle diameter of 1 µm, 3.0 parts by weight of an acrylic resin binder, 3.5 parts by weight of an α-terpineol solvent, and 0.3 parts by weight of a dispersant.
   A conductor containing paste B was prepared by mixing 100 parts by weight of tungsten particle having the average particle diameter of 3 µm, 1. 9 parts by weight of an acrylic resin binder, 3.7 parts by weight of an α-terpineol solvent, and 0.2 parts by weight of a dispersant.
   The conductor containing paste A was printed on the green sheet by screen printing to form the conductor containing paste layer for a resistance heating element. The printing patterns are made to be concentric patterns with a width of 10mm and a thickness of 12µm. A conductor containing paste layer having the electrostatic electrode pattern with the shapes shown in Fig. 3 was also formed in another green sheet. The thickness of the conductor containing paste layer was 10µm.
   Further, the through holes for conductor-filled through holes for connecting external terminals were filled with the conductor containing paste B.
   On the green sheet 50 on which the above-mentioned treatment was finished, 34 green sheets 50', on which no tungsten paste was printed, were laminated on the upper side (the heating face) and 13 green sheets 50', on which no tungsten paste was printed, were laminatedonthe lower side, respectively. Further, the green sheet 50 on which conductor containing paste layer of the electrostatic electrode patternswasprintedwaslaminated thereon and furthermore, 2 green sheets 50' , on which no tungsten paste was printed, were laminated and the resulting body was pressed to be integrated each other at 130 °C and 80 kg/cm²-pressure to obtain a lamination [Fig. 1(a)].
(4) Next, the obtained lamination was degreased at 600 °C for 5 hours in nitrogen gas and hot pressed at 1,890 °C for 3 hours under a pressure of 150 kg/cm² to obtain an aluminum nitride plate-shaped body with the thickness of 3 mm. It was cut in a disk-shaped piece having 230 mm-diameter to obtain a plate-shaped body made of an aluminum nitride and comprising resistance heating elements 5 having the thickness of 6 µm and the width of 10 mm inside thereof, and the chuck positive electrostatic layer 2 and the chuck negative electrostatic layer 3 having the thickness of 10 µm inside thereof [Fig. 1(b)].
(5) Next, after grinding the plate-shaped body obtained in (4) by a diamond grind stone, a mask was placed and bottomed holes (the diameter: 1.2 mm, the depth: 2.0 mm) for a thermocouple were provided in the surface by blast treatment by SiC or the like.
(6) Further, blind holes 35, 36 were formed by hollowing out the parts where the conductor-filled through holes were formed [Fig. 1(c)] and external terminals 6, 18 made of Kovar were connected to the blind holes 35, 36 by using a blazing gold comprising Ni-Au and carrying out'heat reflow at 700 °C [Fig. 1(d)].
   Still more, connection of the external terminals is desirable to have a structure wherein a support of tungsten supports at three points. That is because the connection reliability can be assured.
(7) Next, a plurality of thermocouples were buried in the bottomed holes for temperature control to complete the manufacture of the electrostatic chuck having the resistance heating elements.

### (Example 2,3 and Comparative Example 1) Manufacturing of an electrostatic chuck (reference to Fig. 1)

Except that the drying condition and surface roughness were set as shown in the Table.1, an electrostatic chuck was produced in the same way as in Example 1.

After the silicon wafer 9 was placed on and adsorbed on the thus produced electrostatic chucks according to Examples 1 to 3 and Comparative Example 1, electricity was applied to the ceramic substrate so that the temperature of. the ceramic substrate was raised to 400 °C. Then, the temperature of each part of the surface of the silicon wafer was measured by a thermoviewer (IR62012-0012, made by Japan Datum Company) to obtain the difference of the highest temperature and the lowest temperature thereof. The results are shown in Tablel, which is listed below.

Also, the silicon wafer divided into 12 parts, was placed on the electrostatic chuck and heated to 400 °C. Then, a voltage of 1 kV was applied thereto to measure the chucking force of each part by a load cell (Autograph, AGS-50A, made by Shimadzu Corp.) and the difference of the highest value and the lowest value was obtained.

The surface roughness, Rmax, was measured by a surface roughness profiler (P-11, made by KLA-Tencor) with a measurement condition of, measurement length:5000µm, scanning speed:50µm/sec, load weight:3mg, Sampling rate:100Hz, Waviness Filter:80µm.

**Table.1**

| | Drying condition the green sheet | Surface of roughness Rmax (µm) | Difference of chucking force (g/cm²) | Temperature difference of the face (°C) |
|---|---|---|---|---|
| Example 1 | 80°C, 15min 150°C, 15min | 50 | 20 | 6 |
| Example 2 | 120°C, 20min 150°C, 20min | 180 | 20 | 7 |
| Example 3 | 60°C, 20min 100°C, 20min | 10 | 20 | 6 |
| Comparative Example 1 | 150°C, 15min 150°C, 15min | 210 | 50 | 18 |

As is clear from the result shown in the above-mentioned Table. 1, a dispersion of the surface temperature of the silicon wafer of the electrostatic chucks according to Examples 1 to 3, which used a green sheet having a surface roughness Rmax of 200µm or lower, was 7°C or less, which was small. On the other hand, a dispersion of the surface temperature of the silicon wafer of the electrostatic chucks according to the Comparative Example 1, which used a green sheet having a surface roughness Rmax of 210µm, was 18°C, which was large, and also, regarding the chucking force of the electrostatic electrode, a dispersion depending on place existed.

### (Examples 4 to 6) Manufacturing of a ceramic heater (reference to Fig.11)

(1) A green sheet of 0.47 mm-thickness was obtained by: preparing a paste with a viscosity of 20000 cP (20Pa • s) produced by mixing 100 parts by weight of an aluminum nitride powder (the average particle diameter of 1.1 µm, produced by Tokuyama Corp.) , 4 parts by weight of yttrium oxide (Y₂O₃:Yittria, the average particle diameter of 0. 4 µm), 11.5 parts by weight of an acrylic binder, 0.5 parts by weight of a dispersant, and 53 parts by weight of alcohol containing 1-butanol and ethanol; and forming the paste by doctor blade method. The surface roughness of the green sheet and the drying condition is shown in the Table.2.
(2) Next, the green sheet was dried at 80 °C for 5 hours and then, parts to be through holes for letting lifter pins, for supporting a silicone wafer, pass through; and parts to be conductor-filled through holes; and the like were formed by punching.
(3) A conductor containing paste A was prepared by mixing 100 parts by weight of tungsten carbide particle having the average particle diameter of 1 µm, 3.0 parts by weight of an acrylic binder, 3.5 parts by weight of an α-terpineol solvent, and 0.3 parts by weight of a dispersant.
   A conductor containing paste B was prepared by mixing 100 parts by weight of tungsten particle having the average particle diameter of 3 µm, 1.9 parts by weight of an acrylic binder, 3.7 parts by weight of an α-terpineol solvent, and 0.2 parts by weight of a dispersant.
   After filling the conductor containing paste B in the through holes for conductor filled through holes, the conductor containing paste A was printed on the green sheet by screen printing to form the conductor containing paste layer for a resistance heating element62. The printing patterns are made to be concentric patterns and the conductor containing paste layer has a width of 10mm and a thickness of 12µm.
   On the green sheet on which the above-mentioned treatment was finished, 37 green sheets, on which no tungsten paste was printed, were laminated on the upper side (the heating face) and 13 green sheets, on which no tungsten paste was printed, were laminated on the lower side, respectively at 130 °C and 80 kg/cm²-pressure.
(4) Next, the obtained lamination was degreased at 600 °C for 5 hours in nitrogen gas and hot pressed at 1,890 °C and for 10 hours under a pressure of 150 kg/cm² to obtain an aluminum nitride sintered body with the thickness of 3 mm. It was cut in a disk-shaped body having 230 mm-diameter to obtain a ceramic substrate having resistance heating elements 62 with the thickness of 6 µm and the width of 10 mm (aspect ratio: 1666) inside thereof.
(5) Next, after grinding the plate-shaped body obtained in (4) by a diamond grind stone, a mask was placed and bottomed holes for a thermocouple were provided in the surface by blast treatment by SiC or the like.
(6) Further, blind holes were formed by hollowing out the plate-shaped body. Then, after external terminals 63 having a section in T-figure shape were inserted therein, the external terminals 63 were connected to the end parts of the resistance heating element62 by using a blazing gold comprising Ni-Au (Au: 81. 5 % by weight, Ni:18.4 % by weight, impurities:0.1 % by weight) and carrying out heating and reflowing at 970 °C.
(7) Next, a plurality of thermocouples for temperature control were buried in the bottomed holes , followedby the f illing with polyimide resin and curing thereof at 190°C for 2 hours, to complete the manufacture of the ceramic heater.

### (Comparative Example 2) Manufacturing of a ceramic heater (reference to Fig. 11)

Except that the surface roughness, Rmax, of the surface of the green sheet was set to 210µm and the drying condition was set as shown in the Table.2, a ceramic heater was produced in the same way as in Example 4.

While: applying the electricity to thus produced ceramic heater according to Examples 4 to 6 and Comparative Example 2; and maintaining the temperature of the ceramic substrate at 400 °C, the temperature of each part of the heating face of the ceramic substrate was measured by a thermoviewer (IR62012-0012, made by Japan Datum Company) to obtain the difference of the highest temperature and the lowest temperature of the heating face. The results are shown in Table2, which is listed below.

**Table.2**

| | Drying condition of the green sheet | Surface roughness Rmax (µm) | Temperature difference of heating face (°C) |
|---|---|---|---|
| Example 4 | 80°C, 15min 150°C, 15min | 50 | 4 |
| Example 5 | 120°C, 20min 150°C, 20min | 180 | 5 |
| Example 6 | 60°C, 20min 100°C, 20min | 10 | 4 |
| Comparative Example 2 | 150°C, 15min 150°C, 15min | 210 | 15 |

As shown in the above Table . 2 , a difference of the temperature was 4 to 5°C on the ceramic heaters according to Examples 4 to 6 , on the other hand, a difference of the temperature in the ceramic heater according to Comparative Example 2 was 15°C, which was large.

### Test Example 1

Except that the diameter of the ceramic substrate which constitutes the electrostatic chuck was made to be 150mm, the electrostatic chuck was manufactured in the same way as in

### Comparative Example 1.

After that, the temperature of the electrostatic chuck was raised to 400 °C and a voltage of 1kV was applied. Then, the difference of the highest temperature and the lowest temperature of the surface of the silicon wafer was measured. As a result, the temperature difference was 9°C.

### Test Example 2

Except that the diameter of the ceramic substrate which constitutes the ceramic heater was made to be 150mm, the ceramic heater was manufactured in the same way as in Comparative Example 2.

After raising the temperature thereof to 400 °C, the difference of the highest temperature and the lowest temperature of the surface of the silicon wafer was measured. As a result, the temperature difference was 7°C.

### (Example 7) Manufacturing of an electrostatic chuck (reference to Fig. 1)

(1) A green sheet of 0.47 mm-thickness having a surface roughness, Rmax, of 10 µm was obtained by: preparing a paste with a viscosity of 40000 cP (40Pa•s) produced by mixing 93 parts by weight of alumina, 5 parts by weight of SiO₂, 0.5 parts by weight of CaO, 0.5 parts by weight of MgO, 0. 5 parts by weight of TiO₂, 11.5 parts by weight of an acrylic binder, 5 parts by weight of a dispersant, and 53 parts by weight of alcohol containing 1-butanol and ethanol ; and forming the paste by doctor blade method followed by the 20 minutes' drying at 60 °C and the 20 minutes' drying at 100 °C.
(2) Next, after the green sheet was dried at 80 °C for 5 hours, to the green sheet which has the necessity for processing, parts to be through holes having a diameter of 1.8 mm, 3.0 mm and 5.0 mm for letting semiconductor wafer lifter pins pass through; and parts to be conductor-filled through holes for connecting the external terminals were formed by punching.
(3) A conductor containing paste B was prepared by mixing 100 parts by weight of tungsten particle having the average particle diameter of 3 µm, 1.9 parts by weight of an acrylic resin binder, 3.7 parts by weight of an α-terpineol solvent, and 0.2 parts by weight of a dispersant.
   The conductor containing paste B was printed on the green sheet by screen printing to form the conductor containing paste layer for a resistance heating element. The printing patterns were made to be concentric patterns. Also a pattern for an electrostatic electrode of bipolar was also printed on another green sheet.
(4) Further, the through holes for conductor-filled through holes for connecting external terminals were filled with the conductor containing paste B.
   On the green sheets on which a pattern of the resistance heating element was printed and the green sheet on which a pattern of the electrostatic electrode was printed, 34 to 60 green sheets, on which no tungsten paste was printed, were laminated on the upper side (the heating face) and 13 to 30 green sheets, on which no tungsten paste was printed, were laminated on the lower side, respectively. The resulting body was pressed to be integrated each other at 130 °C and 80 kg/cm²-pressure to obtain a lamination.
(5) Next, the obtained lamination was degreased at 600 °C for 5 hours in air and hot pressed at 1,600 °C for 3 hours under a pressure of 150 kg/cm² to obtain an aluminum plate-shaped body with the thickness of 3 mm and the diameter of 210mm. The substrate was formed with resistance heating elements having the thickness of 6 µm and the width of 10 mm inside thereof.
(6) Next, after grinding the plate-shaped body obtained in (5) by a diamond grind stone, a mask was placed and bottomed holes (the diameter: 1.2 mm, the depth: 2.0 mm) for a thermocouple were provided in the surface by blast treatment by SiC and the like.
(7) Further, blind holes were formed by hollowing out the parts where the conductor-filled through holes were formed and external terminals made of Kovar were connected thereto by heating and reflowing at 700 °C using a blazing gold comprising Ni-Au.
   Still more, connection of the external terminals is desirable to have a structure wherein a support of tungsten supports at three points. That is because the connection reliability can be assured.
(8) Next, a plurality of thermocouples were buried in the bottomed holes for temperature control to complete the manufacture of the hot plate having the electrostatic electrode .

### (Comparative Example 3)

Except that the green sheet was dried at 100°C for 15 minutes and then dried at 150°C for 15 minutes to obtain the green sheet having a surface roughness, Rmax, of 210 µm and a thickness of 0.47mm, a hot plate having an electrostatic electrode was produced in the same way as in Example 7.

On the hot plates according to Examples 7 and Comparative Example 3, the difference of the chucking force was measured in the same way as in Examples 1 to 3. In the case of Example 7, the difference of the chucking force was 20g/cm², the temperature difference of the silicone wafer surface when the temperature was raised to 150°C was 6°C. In the case of Comparative Example 3, the difference of the chucking force was 40g/cm², the temperature difference of the silicone wafer surface when the temperature was raised to 150°C was 20°C.

Although alumina has low thermal conductivity, the temperature for usage is as low as at 150°C, thus the difference of the temperature itself is not different from that in the case of an aluminum nitride is used.

As mentioned above, the present invention shows significant effect in the case of producing an electrostatic chuck or a ceramic heater which has a diameter of the ceramic substrate exceeding 150mm.

### Industrial Applicability

As explained above, in the manufacturing method of the electrostatic chuck of the present invention, the surface roughness, Rmax, of the green sheet is set to be 200 µm or less so that the dispersion of the chucking force of the produced electrostatic chuck depending on place is eliminated, thus the semiconductor wafer is evenly adsorbed.

Also, in the manufacturing method of the ceramic heater of the present invention, the surface roughness, Rmax, of the green sheet is set to be 200 µm or less so that the dispersion of the calorific value of the resistance heating element depending on place is eliminated, thus the semiconductor wafer is evenly heated.

## Claims

1. A process for manufacturing an electrostatic chuck comprising steps of:
printing a conductor containing paste for an electrode on a green sheet which has a surface roughness, Rmax, of 200 µm or less;
forming a lamination by stacking another green sheet or other green sheets on said green sheet; and then
sintering said lamination.

2. The process for manufacturing an electrostatic chuck according to Claim 1,
wherein
the manufactured electrostatic chuck is in a disc shape having a diameter exceeding 150 mm.

3. A process for manufacturing a ceramic heater comprising steps of:
printing a conductor containing paste for a resistance heating element on a green sheet which has a surface roughness, Rmax, of 200 µm or less;
forming a lamination by stacking another green sheet or other green sheets on said green sheet; and then
sintering said lamination.

4. The process for manufacturing a ceramic heater according to Claim 3,
wherein
the manufactured ceramic heater is in a disc shape having a diameter exceeding 150 mm.
